# EUROPEAN PATENT SPECIFICATION

(11) **EP 2 978 025 B1**
(45) Date of publication and mention of the grant of the patent: **19.09.2018**
(21) Application number: 15177571.5
(22) Date of filing: 20.07.2015
(51) Int. Cl.: H01L 31/0224, H01L 31/05, H01L 31/068

(54) **SOLAR CELL AND SOLAR CELL MODULE CONTAINING THE SAME**
SOLARZELLE UND SOLARZELLENMODUL DAMIT
CELLULE SOLAIRE ET MODULE DE CELLULE SOLAIRE LE CONTENANT

(30) Priority: 24.07.2014 TW 103125321
(43) Date of publication of application: 27.01.2016
(73) Proprietor: Motech Industries Inc., New Taipei City 222 (TW)
(72) Inventor: CHANG, Peng-Heng, 222 New Taipei City (TW); WANG, Chien-Chun, 222 New Taipei City (TW); LU, Yen-Ting, 222 New Taipei City (TW)
(74) Representative: Lang, Christian

(56) References cited:
- EP-A2- 2 525 412
- JP-A- 2013 211 341

## Description

This disclosure relates to a solar cell, more particularly to a crystalline silicon solar cell. This disclosure also relates to a solar cell module containing the crystalline silicon solar cell.

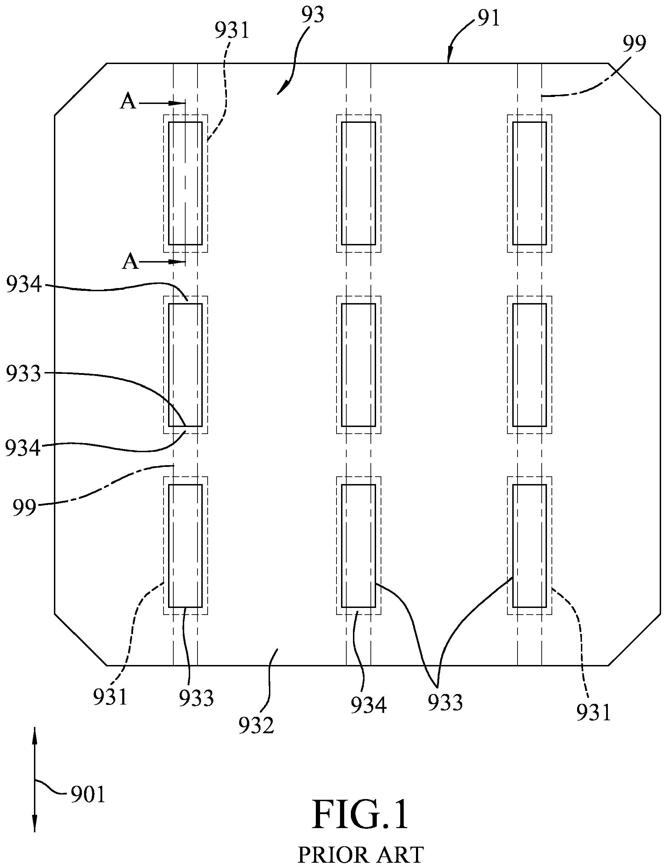

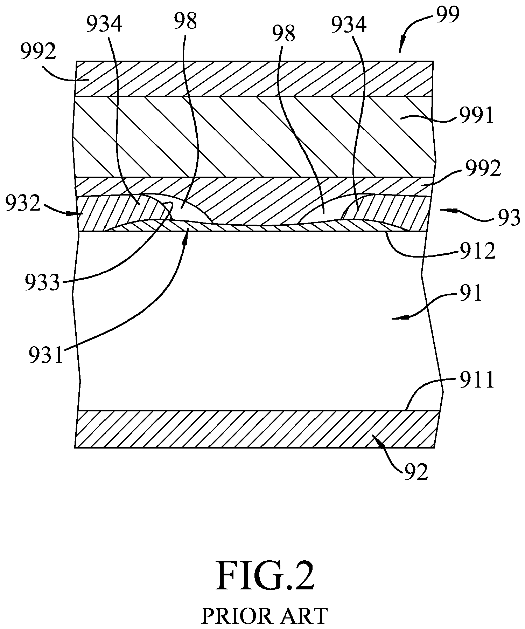

Referring to Figures 1 and 2, a conventional solar cell is shown to include a photovoltaic substrate (91), a front electrode (92) disposed on an light-receiving surface (911) of the photovoltaic substrate (91), and a back electrode (93) disposed on a back surface (912) of the photovoltaic substrate (91).

The back electrode (93) includes a plurality of bus electrode segments (931) and a collector layer (932). The bus electrode segments (931) are arranged on the back surface (912) of the photovoltaic substrate (91), are spaced apart from each other, and extend along a first direction (901). The collector layer (932) covers the back surface (912) of the photovoltaic substrate (91) and peripheries of the bus electrode segments (931). The collector layer (932) has a plurality of rectangular openings (933) respectively corresponding to the bus electrode segments (931) so as to expose the bus electrode segments (931).

Generally, a plurality of the solar cells and other components are packaged to form a solar cell module. In manufacture, a ribbon (99) is soldered to the solar cells in the same column by having the ribbon (99) soldered to the front electrode (92) of every other solar cell and the back electrode (93) of the solar cell next to the every other solar cell so as to electrically connect the solar cells in the same column. The ribbon (99) usually includes a copper-based material (991) and a solder layer (992) encapsulating the copper-based material (991).

When soldering the ribbon (99) onto the back electrode (93), the ribbon (99) is disposed above and at a position corresponding to the bus electrode segments (931) along the first direction (901). The solder layer (992) of the ribbon (99) is then heated to a molten state so as to flow through the openings (933) and to contact the bus electrode segments (931). After the solder layer (992) is solidified by cooling, the ribbon (99) is connected to the bus electrode segments (931).

Since the sizes of the openings (933) are smaller than those of the bus electrode segments (931), the collector layer (932) has a plurality of overlapping regions (934) correspondingly overlapping the peripheries of the bus electrode segments (931), so that there is a height difference between each of the overlapping regions (934) and a corresponding one of the bus electrode segments (931), and the thickness of the back electrode (93) is uneven. As a consequence, when the ribbon (99) is soldered onto the back electrodes (93), the exposed surfaces of the bus electrode segments (931) cannot come into full contact with the solder layer (992) of the ribbon (99), thereby forming voids (98) between the bus electrode segments (931) and the solder layer (992). This results in an undesirable reduction in the effective soldering area and the bonding strength between the ribbon (99) and the bus electrode segments (931).

Additionally, during the procedures of lamination and/or soldering encapsulation, stress may concentrate at the overlapping regions (934) of the collector layer (932), especially at the corners of the rectangular openings (933), which may cause the photovoltaic substrate (91) to crack from areas near the corners of the openings (933).

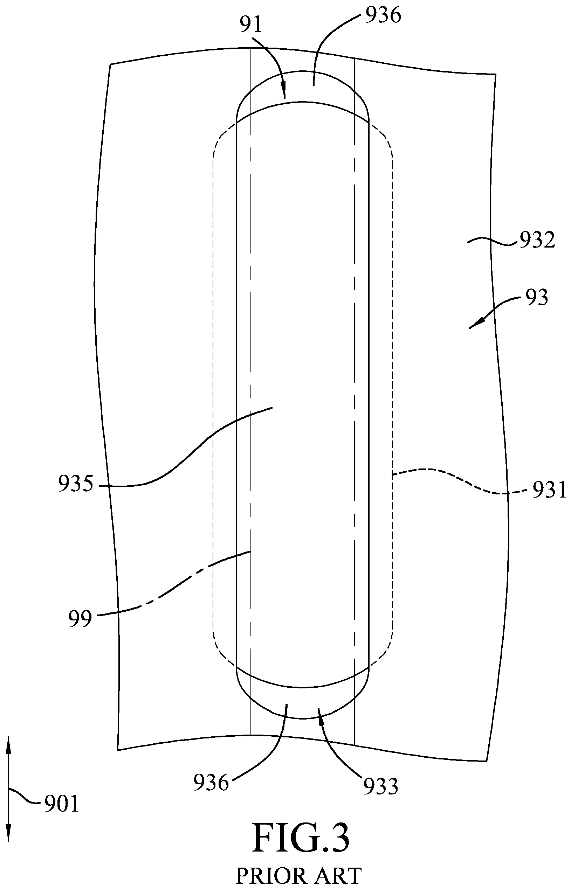

With reference to Figure 3, in order to overcome the aforesaid drawbacks, there has been proposed an improved solar cell structure. As shown, the relative lengths of the openings (933) and the bus electrode segments (931) in the first direction (901) are adjusted so that two opposite end portions of each of the bus electrode segments (931) are not covered by the collector layer (932).Thus, each of the openings (933) has a main opening portion (935) which is disposed above and corresponds to a corresponding one of the bus electrode segments (931), and two end opening portions (936) which is disposed at opposite ends of the main opening portion (935) along the first direction (901) and which allow the photovoltaic substrate (91) to be exposed. Through such adjustment, the effective soldering area and the bonding strength between the ribbon (99) and the bus electrode segments (931) can be increased.

Additionally, by configuring the edges of the end opening portions (936) of the openings (933) and the edges of the opposite end portions of the bus electrode segments (931) in the first direction (901) to have an arcuate shape, as shown in Figure 3, the aforesaid cracking problem due to concentrated stress can be alleviated.

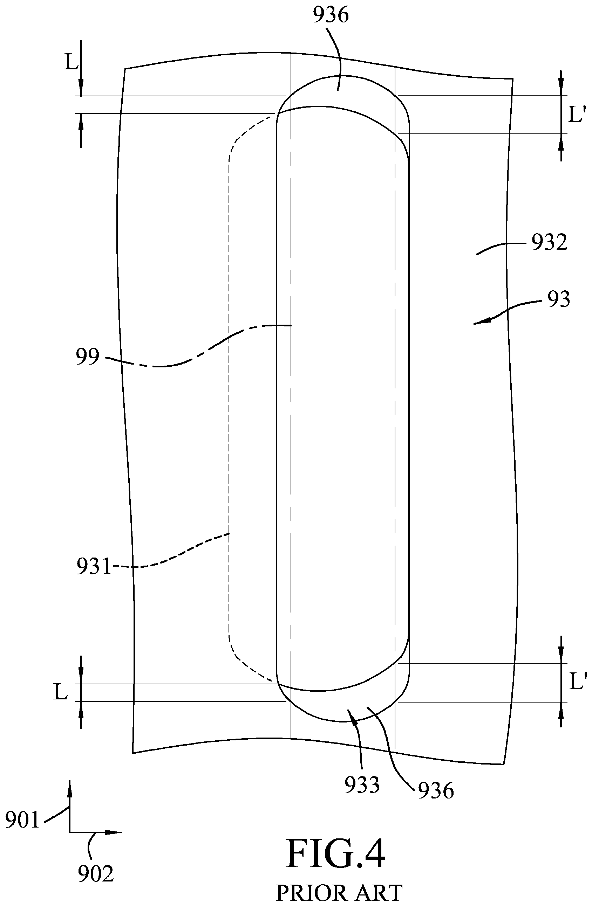

However, due to the arcuate shape of the edges of the end opening portions (936) of the openings (933) and the edges of the opposite end portions of the bus electrode segments (931), in a screen printing procedure for forming the back electrodes (93), more precise alignment of the openings (933) with the corresponding bus electrode segments (931) is required. Otherwise, misalignment such as that illustrated in Figure 4 may occur during the screen printing procedure. As shown, the openings (933) deviate from the bus electrode segments (931) in a second direction (902) transverse to the first direction (901) so that the lengths (L, L') of each of the end opening portions (936) in the first direction (901) are significantly different, which may negatively affect the effective soldering area and the bonding strength between the ribbon (99) and the bus electrode segments (931).

Since a screen printing machine unavoidably has a certain amount of alignment error, and the margin for alignment error between the arcuate edges of the openings
(933) and the arcuate edges of the bus electrode segments (931) in the second direction (902) is relatively low, the production yield is reduced.

From document EP 2 525 412 A2 a solar cell comprising a semiconductor substrate, an emitter region, a first electrode, a second electrode and a second electrode current collector is known, wherein the first electrode is positioned on the semiconductor substrate and connected to the emitter region, and wherein the second electrode is positioned on the semiconductor substrate and connected thereto, and wherein the second electrode connector is positioned on the semiconductor substrate and connected to the second electrode, wherein the second electrode forms a plurality of openings, with each opening exposing a portion of the substrate and exposing a portion of a conductor of a number of conductors of the second electrode connector each placed at the position of an opening and interconnected via a conductive film, respectively.

Document JP 2013211341 A discloses a solar cell having a collection electrode for collecting a current and an extraction electrode for extracting a current on the rear surface. The collection electrode has a substantially rectangular aperture. The extraction electrode consists of a substantially rectangular electrode body which is in parallel with the aperture, a plurality of electrode protrusions extending from the long side of the electrode body. Therefore, an object of this disclosure is to provide a solar cell which has a relatively high error tolerance so as to enhance production yield.

Another object of this disclosure is to provide a solar cell module which contains the solar cell.

According to one aspect of this disclosure, there is provided a solar cell, which includes a photovoltaic substrate, a front electrode, and a back electrode.

The photovoltaic substrate has a light-receiving
surface and a back surface opposite to the light-receiving surface.

The front electrode is disposed on the light-receiving surface of the photovoltaic substrate.

The back electrode is disposed on the back surface of the photovoltaic substrate, and includes a collector layer and a bus electrode.

The collector layer is disposed on the back surface of the photovoltaic substrate and has at least one collector opening which extends along a first direction and which includes a first end portion, a second end portion opposite to the first end portion, a main opening portion between the first and second end portions, and a first expansive opening portion formed at the first end portion. The first expansive opening portion has a first outer expansive edge distal from the main opening portion and being at least partially arcuate. The first outer expansive edge extends along a second direction transverse to the first direction. The first expansive opening portion has a width larger than a width of the main opening portion.

The bus electrode is disposed on the back surface of the photovoltaic substrate and includes at least one bus electrode segment extending along the first direction and corresponding in position to the collector opening. The at least one bus electrode segment is exposed from the at least one collector opening, and has a first end portion exposed from the first expansive opening portion and a second end portion opposite to the first end portion of the at least one bus electrode segment in the first direction.

According to another aspect of this disclosure, there is provided a solar cell module, which includes a first plate, a second plate opposite to the first plate, the aforesaid solar cell disposed between the first and second plates, and an encapsulating material disposed between the first and second plates and encapsulating the solar cell.

In the solar cell of this disclosure, the first expansive opening portion has a width larger than a width of the main opening portion. When the at least one collector opening of the collector layer is deviated from the at least one bus electrode segment of the bus electrode layer in position, the spacing difference between the first outer expansive edge of the first expansive opening portion and the at least one bus electrode segment in the first direction is relatively small. Therefore, under the aforesaid circumstance that a screen printing machine unavoidably has a certain amount of alignment error, a tolerance for error in alignment between the at least one collector opening and the at least one bus electrode segment may be increased and the production yield of the solar cell of this disclosure may be enhanced thereby.

Other features and advantages of this disclosure will become apparent in the following detailed description of the embodiments with reference to the accompanying drawings, of which:
Figure 1 is a schematic view showing a back surface of a conventional solar cell, a plurality of ribbons being indicated by imaginary lines;
Figure 2 is a partial sectional schematic view of the conventional solar cell taken along line A-A of Figure 1, showing the back surface of the conventional solar cell facing upward and the relationship between the back surface and the ribbons ;
Figure 3 is a partial schematic rear view of another conventional solar cell, a plurality of ribbons being likewise indicated by imaginary lines;
Figure 4 is a partial schematic rear view of the conventional solar cell of Figure 3, illustrating misalignment between an opening of a collector layer and a bus electrode segment in a second (horizontal) direction, the ribbons being likewise indicated by imaginary lines;
Figure 5 is a partial schematic sectional view of an embodiment of a solar cell module according to this disclosure;
Figure 6 is a schematic front view of a first embodiment of a solar cell according to this disclosure;
Figure 7 is a schematic rear view of the first embodiment of the solar cell, a plurality of ribbons being indicated by imaginary lines, but with a passivation layer and a plurality of linear openings of the solar cell omitted;
Figure 8 is a partial schematic sectional view taken along line B-B of Figure 7, in which a back surface of the solar cell is shown to face upwardly so as to facilitate illustration, and the ribbons indicated by imaginary lines are omitted;
Figure 9 is a partially enlarged view of Figure 7, primarily illustrating the relationship between a collector opening of a collector layer and a bus electrode segment of the solar cell, the ribbons indicated by imaginary lines being omitted;
Figure 10 is an enlarged view similar to Figure 9, illustrating another form of the first embodiment of the solar cell;
Figure 11 is a partially enlarged view similar to Figure 9, illustrating a situation in which a collector opening is not aligned with a bus electrode segment in a second direction, the passivation layer and the linear openings being likewise omitted;
Figure 12 is a partially enlarged bottom view of a second embodiment of a solar cell according to this disclosure, illustrating a configuration of a back electrode of the second embodiment of the solar cell, but with a passivation layer and a plurality of linear openings omitted, ribbons indicated by imaginary lines being likewise omitted;
Figure 13 is a partially enlarged schematic view similar to Figure 12, illustrating a third embodiment of a solar cell according to this disclosure, a passivation layer and a plurality of linear openings being omitted;
Figure 14 is a partially enlarged schematic view similar to Figure 12, illustrating a fourth embodiment of a solar cell according to this disclosure, a passivation layer and a plurality of linear openings being likewise omitted;
Figure 15 is a partially enlarged schematic view similar to Figure 12, illustrating a fifth embodiment of a solar cell according to this disclosure, a passivation layer and a plurality of linear openings being omitted;
Figure 16 is a partially enlarged schematic view similar to Figure 12, illustrating a sixth embodiment of a solar cell according to this disclosure, a passivation layer and a plurality of linear openings being omitted;
Figure 17 is a partially enlarged schematic view similar to Figure 12, illustrating a seventh embodiment of a solar cell according to this disclosure, a passivation layer and a plurality of linear openings being omitted;
Figure 18 is a partially enlarged schematic view similar to Figure 12, illustrating an eighth embodiment of a solar cell according to this disclosure, a passivation layer and a plurality of linear openings being omitted; and
Figure 19 is a partially enlarged schematic view similar to Figure 12, illustrating a ninth embodiment of a solar cell according to this disclosure, a passivation layer and a plurality of linear openings being omitted.

Before this disclosure is described in greater detail with reference to the accompanying embodiments, it should be noted herein that like elements are denoted by the same reference numerals throughout the disclosure.

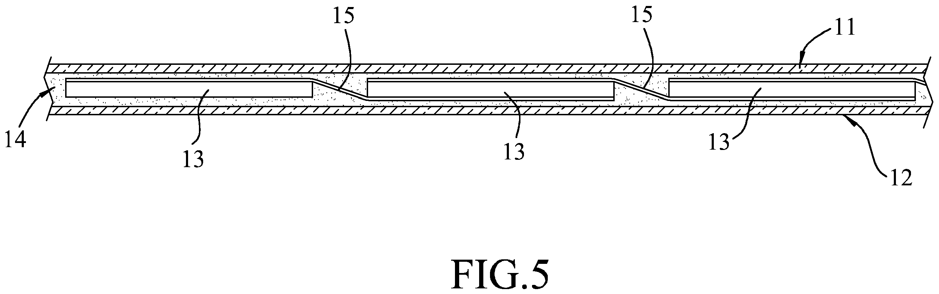

Referring to Figure 5, an embodiment of a solar cell module according to this disclosure is shown to include a first plate (11), a second plate (12) opposite to the first plate (11), a plurality of solar cells (13) disposed in an array between the first and second plates (11, 12), and an encapsulating material (14) disposed between the first and second plates (11, 12) and encapsulating the solar cells (13).

There is no specific limitation on the material for the first and second plates (11, 12) as long as the material for the plates at alight-receiving side of the solar cells (13) is light-transmissive. Examples of the material for the first and second plates (11, 12) include, but are not limited to, a glass plate and a plastic plate. Examples of the encapsulating material (14) include, but are not limited to, light-transmissive ethylene-vinyl acetate (EVA) copolymer and other related materials appropriate for the solar cell module encapsulation. The solar cells (13) are electrically connected to each other via a plurality of ribbons (15). In the embodiment, since the solar cells (13) have the same configurations, only one of the solar cells (13) is illustrated in the following description. Alternatively, the solar cells (13) may have different configurations.

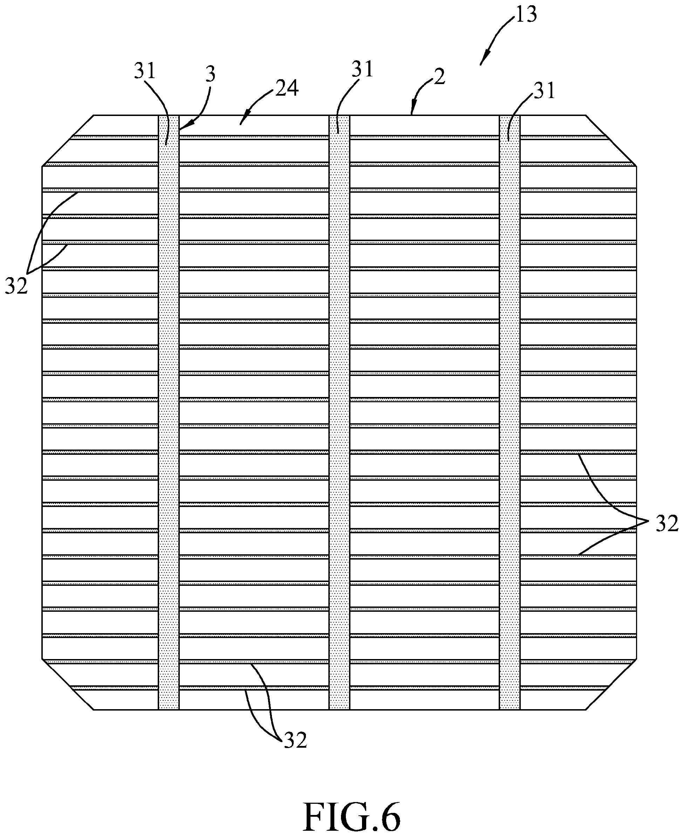

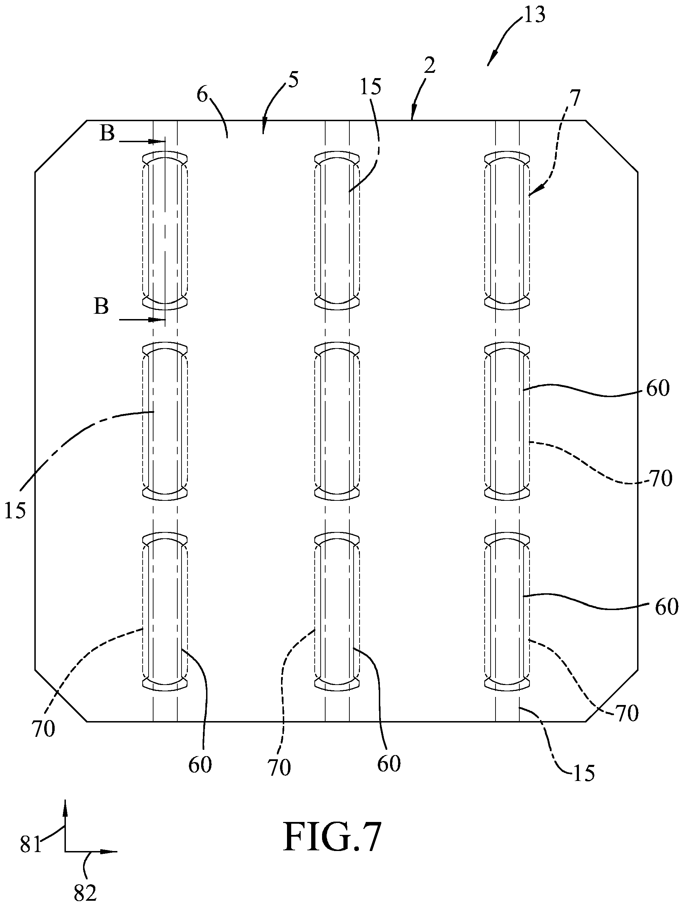

Referring to Figures 6, 7, and 8, a first preferred embodiment of the solar cell (13) includes a photovoltaic substrate (2), an antireflective layer (24), a front electrode (3), a passivation layer (4), and a back electrode (5). In Figure 7, imaginary lines are used to indicate the ribbons (15) so as to illustrate the positional relationship between the ribbons (15) and the solar cell (13).

The photovoltaic substrate (2) maybe a p-type or n-type substrate, and may be a single-crystalline or multi-crystalline silicon substrate. The photovoltaic substrate (2) has a light-receiving surface (21), a back surface (22) opposite to the light-receiving surface (21), and an emitter layer (23) located inside of the light-receiving surface (21). A p-n junction is formed between the emitter layer (23) and the portion of the photovoltaic substrate (2) that is adjacent to the emitter layer (23) . An incident light having a specific waveband may be converted into photocurrent.

The antireflective layer (24) is located on the light-receiving surface (21) and is in contact with the emitter layer (23). The antireflective layer (24) is made of a material such as silicon nitride (SiNₓ) or the like, and is used for increasing the amount of incident light and reducing the surface recombination velocity (SRV) of carriers.

The front electrode (3) is disposed on the light-receiving surface (21) of the photovoltaic substrate (2), and is formed using a conductive paste by screen printing and sintering. In practice, the front electrode (3) includes at least one front bus electrode (31) and a plurality of finger electrodes (32) connected to the front bus electrode (31).

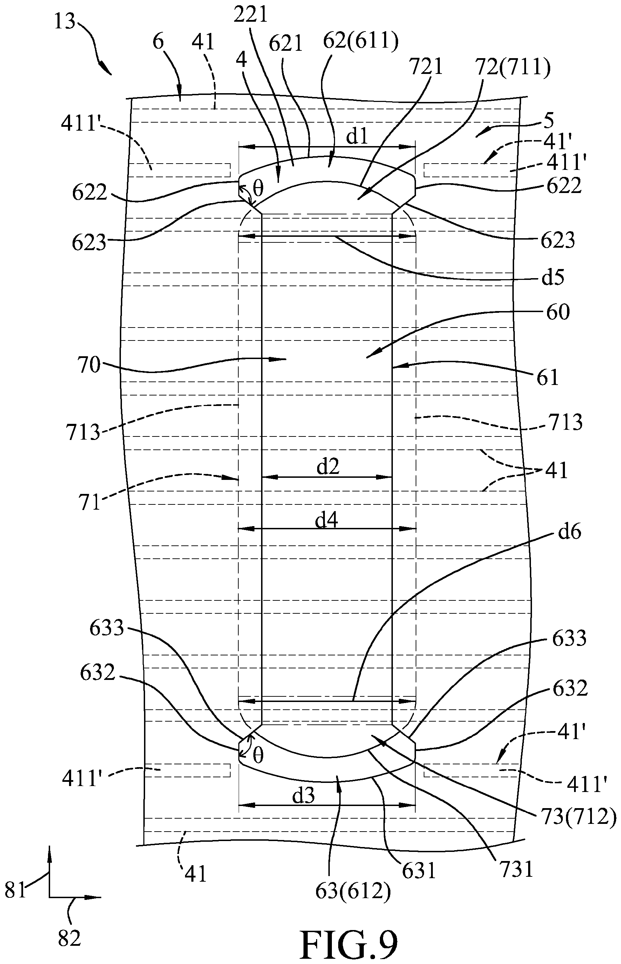

Referring to Figures 7, 8, and 9, the passivation layer (4) is disposed on the back surface (22) of the photovoltaic substrate (2) as a whole layer and between the back surface (22) of the photovoltaic substrate (2) and the back electrode (5) . The term "whole layer" as used herein means that the passivation layer (4) is in the form of a sheet in appearance and covers most of the area of the back surface (22) of the photovoltaic substrate (2). The passivation layer (4) may be made of oxides, nitrides, or combinations thereof, and is used for repairing or reducing the defects on the surface or inside of the photovoltaic substrate (2) so as to reduce the surface recombination velocity of the carriers and to enhance the photoelectric conversion efficiency. In this embodiment, the passivation layer (4) includes a plurality of linear openings (41) that are spaced apart from each other in the first direction (81) and that extend in a second direction (82) transverse to the first direction (81), as best shown in Figure 9.

The back electrode (5) is disposed on the back surface (22) of the photovoltaic substrate (2), and cooperates with the front electrode (3) to conduct the current produced in the photovoltaic substrate (2) outwards. The back electrode (5) includes a collector layer (6) and a bus electrode (7) which are disposed on the passivation layer (4). The collector layer (6) and the bus electrode (7) electrically connect the back surface (22) of the photovoltaic substrate (2) by extending through the linear openings (41) of the passivation layer (4).

The collector layer (6) is disposed on the back surface (22) of the photovoltaic substrate. Specifically, in this embodiment, the collector layer (6) is disposed on the passivation layer (4) as a whole. In addition, the collector layer (6) has a plurality of collector openings (60) which extend along the first direction (81). The collector openings (60) are arranged in sets, and the collector openings (60) in each set are arranged in a straight line along the first direction (81), as best shown in Figure 7.

The bus electrode (7) is disposed on the back surface (22) of the photovoltaic substrate (2), and includes a plurality of bus electrode segments (70) which extend along the first direction (81) .In this embodiment, the bus electrode segments (70) are arranged in sets, and the bus electrode segments (70) in each set are arranged in a straight line along the first direction (81), as best shown in Figure 7.

In this embodiment, since the collector openings (60) overlap and correspond in position to the bus electrode segments (70) respectively, the bus electrode segments (70) can be exposed for connection with the ribbons (15) by soldering and for conducting the current outwards through the ribbons (15).

In this embodiment, the photovoltaic substrate (2) is made of a multi-crystalline silicon substrate. The collector openings (60) are arranged in three columns which are spaced apart from each other in the second direction (82) and which extend along the first direction (81). The bus electrode segments (70) are correspondingly arranged in three columns which are spaced apart from each other in the second direction (82) and which extend along the first direction (81). Alternatively, the collector openings (60) and the bus electrode segments (70) may be arranged in, for example, two columns which are spaced apart from each other in the second direction (82) and which extend along the first direction (81).

In the embodiment, the collector openings (60) have the same configurations and the bus electrode segments (70) also have the same configurations. Therefore, only one of the collector openings (60) and a corresponding one of the bus electrode segments (70) will be illustrated in the following description. Alternatively, the collector openings (60) may have different configurations and the bus electrode segments (70) may have different configurations as well.

The collector opening (60) includes a first endportion (611), a second end portion (612) opposite to the first end portion (611), a main opening portion (61) between the first and second end portions (611, 612), a first expansive opening portion (62) formed at the first end portion (611), and a second expansive opening portion (63) formed at the second end portion (612).

The first expansive opening portion (62) has a first outer expansive edge (621) distal from the main opening portion (61), two first linear segments (622) connected to two opposite ends of the first outer expansive edge (621) and extending along the first direction (81), and two first connecting edges (623) correspondingly interconnecting the first linear segments (622) and the main opening portion (61). The first outer expansive edge (621) of the first expansive opening portion (62) extends along the second direction (82) and is entirely convexed to protrude away from the main opening portion (61). Each of the first linear segments (622) forms an angle (*θ*) greater than 90° with a corresponding one of the first connecting edges (623). In the second direction (82), the first expansive openingportion (62) has a width (d1) larger than a width (d2) of the main opening portion (61).

The second expansive opening portion (63) has a second outer expansive edge (631) distal from the main opening portion (61), two second linear segments (632) connected to two opposite ends of the second outer expansive edge (631) and extending along the first direction (81), and two second connecting edges (633) correspondingly interconnecting the second linear segments (632) and the main opening portion (61). The second outer expansive edge (631) of the second expansive opening portion (63) extends along the second direction (82) and is entirely convexed to protrude away from the main opening portion (61). Each of the second linear segments (632) forms an angle (*θ*) greater than 90° with a corresponding one of the second connecting edges (633). In the second direction (82), the second expansive opening portion (63) has a width (d3) larger than the width (d2) of the main opening portion (61).

Each of the bus electrode segments (70) is exposed from a corresponding one of the collector openings (60), and has a first end portion (711) and a second end portion (712). The first end portion (711) is exposed from the first expansive opening portion (62). The second end portion (712) is opposite to the first end portion (711) of the bus electrode segment (70) in the first direction (81) and is exposed from the second expansive opening portion (63).

Each of the bus electrode segments (70) includes a main electrode portion (71), a first converging electrode portion (72), and a second converging electrode portion (73).

The main electrode portion (71) is between the first and second end portions (711, 712) of the bus electrode segment (70), and has two lateral sides (713) extending along the first direction (81) and spaced apart from each other along the second direction (82). In the embodiment, each of the lateral sides (713) is aligned with a corresponding one of the first linear segments (622) and a corresponding one of the second linear segments (632). That is, the width (d1) of the first expansive opening portion (62) and the width (d3) of the second expansive opening portion (63) are equal to a width (d4) between the lateral sides (713) of the main electrode portion (71).

The first converging electrode portion (72) is disposed at the first end portion (711) of the bus electrode segment (70), is connected with the main electrode portion (71), and converges in the first direction (81) away from the main electrode portion (71). The first converging electrode portion (72) has a first outer edge (721) which is distal from the main electrode portion (71) and which is entirely convexed to protrude away from the main electrode portion (71). At least a part of the first outer edge (721) of the first converging electrode portion (72) is registered with the first expansive opening portion (62). The first outer expansive edge (621) of the first expansive opening portion (62) has a largest width (d1) in the second direction (82), which is not smaller than a largest width (d5) of the first converging electrode portion (72). The first outer expansive edge (621) of the first expansive opening portion (62) has a curvature corresponding to a curvature of the first outer edge (721) of the first converging electrode portion (72). Ideally, the spacing between the first outer expansive edge (621) of the first expansive opening portion (62) and the first outer edge (721) of the first converging electrode portion (72) in the first direction (81) is consistent.

The second converging electrode portion (73) is disposed at the second endportion (712) of the bus electrode segment (70), is connected with the main electrode portion (71) and converges in the first direction (81) away from the main electrode portion (71). The second converging electrode portion (73) has a second outer edge (731) which is distal from the main electrode portion (71) and which is entirely convexed to protrude away from the main electrode portion (71). At least a part of the second outer edge (731) of the second converging electrode portion (73) is exposed from the second expansive opening portion (63). The second outer expansive edge (631) of the second expansive opening portion (63) has a largest width (d3) in the second direction (82), which is not smaller than a largest width (d6) of the second converging electrode portion (73). The second outer expansive edge (631) of the second expansive opening portion (63) has a curvature corresponding to a curvature of the second outer edge (731) of the second converging electrode portion (73). Ideally, the spacing between the second outer expansive edge (631) of the second expansive opening portion (63) and the second outer edge (731) of the second converging electrode portion (73) in the first direction (81) is consistent.

The back surface (22) of the photovoltaic substrate (2) has a plurality of uncovered areas (221) corresponding to the first and second expansive opening portions (62, 63). The uncovered areas (221) are not covered by the bus electrode (7) and the collector layer (6). In practice, the uncovered areas (221) may be covered by other layers of the solar cell (13). For example, in this embodiment, because the passivation layer (4) is disposed between the back surface (22) and the back electrode (5), the uncovered areas (221) are covered by the passivation layer (4).

Specifically, the first end portion (711) of the bus electrode segment (70) is spaced apart from the first outer expansive edge (621) of the first expansive opening portion (62). One of the uncovered areas (221) corresponds in position to the first expansive opening portion (62) of the collector opening (60) and underlies a spacing between the first end portion (711) of the bus electrode segment (70) and the first outer expansive edge (621) of the first expansive opening portion (62). Likewise, the second end portion (712) of the bus electrode segment (70) is spaced apart from the second outer expansive edge (631) of the second expansive opening portion (63) . One of the uncovered areas (221) corresponds in position to the second expansive opening portion (63) of the collector opening (60) and underlies a spacing between the second end portion (712) of the bus electrode segment (70) and the second outer expansive edge (631) of the second expansive opening portion (63).

In addition, as shown in Figure 9, in this embodiment, each of the linear openings (41) of the passivation layer (4) is configured as a continuous strip-shaped opening extending in the second direction (82). However, in practice, each of the linear openings (41) may be composed of a plurality of dot openings or a plurality of segment openings.

Further, at least one linear opening (41') of the linear openings (41) has an imaginary line of extension in the second direction (82) intersecting with a corresponding one of the uncovered areas (221) . That is, the linear opening (41') does not actually extend across the corresponding one of the uncovered areas (221) ; only the imaginary line of extension of the linear opening (41') passes through the corresponding one of the uncovered areas (221). In other words, the linear opening (41') includes two linear opening segments (411') disposed respectively at two opposite sides of the corresponding one of the uncovered areas (221).

In order to ensure that the linear opening segments (411') do not extend across the corresponding one of the uncovered areas (221), the linear opening segments (411') may be configured such that the common imaginary line of extension of the linear opening segments (411') of the linear opening (41') intersect with a corresponding one of the first and second expansive opening portions (62, 63). Since the linear opening segments (411') do not extend across the corresponding one of the uncovered areas (221), the uncovered areas (221) may be entirely covered by the passivation layer (4) so as to ensure the passivation effect and to reduce any effect caused by outside pollutants.

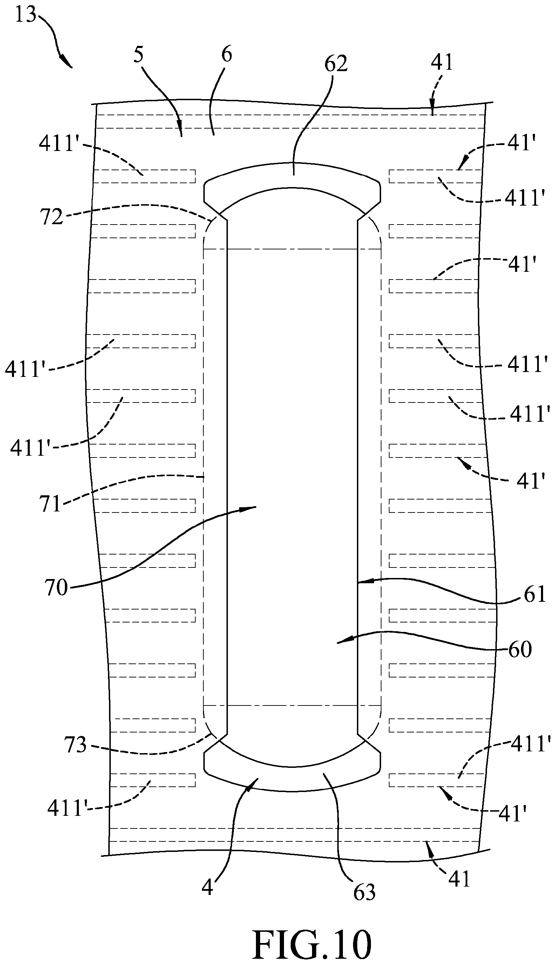

Referring to Figure 10, in practice, the linear openings (41') may be configured to be not extending across and below the bus electrode segment (70), such that the linear opening segments (411') of each linear opening (41') are disposed at two opposite sides of the bus electrode segment (70), the first expansive opening portion (62), or the second expansive opening portion (63). Thus, the bus electrode segment (70) is isolated from the back surface (22) of said photovoltaic substrate (2) by the passivation layer (4) so that the bus electrode segment (70) does not come into contact with the back surface (22) of the photovoltaic substrate (2).

Referring further to Figures 7, 8, and 9, each of the first and second converging electrode portions (72, 73) of the bus electrode segment (70) has a relatively small area covered by the collector layer 6. The uncovered areas (221) of the back surface (22) of said photovoltaic substrate (2) correspond to the first and second expansive opening portions (62, 63) and are not covered by the bus electrode (7) and the collector layer (6). Therefore, the effective soldering area between the bus electrode segment (70) and the ribbon (15) is increased, and the bonding strength between the back electrode (5) and the ribbon (15) is enhanced. Additionally, the problem caused by the concentrated stress encountered in the prior art may be reduced by the arcuate design of the first and second outer expansive edges (621, 631) of the collector opening (60) and the first and second outer edges (721, 731) of the bus electrode segment (70).

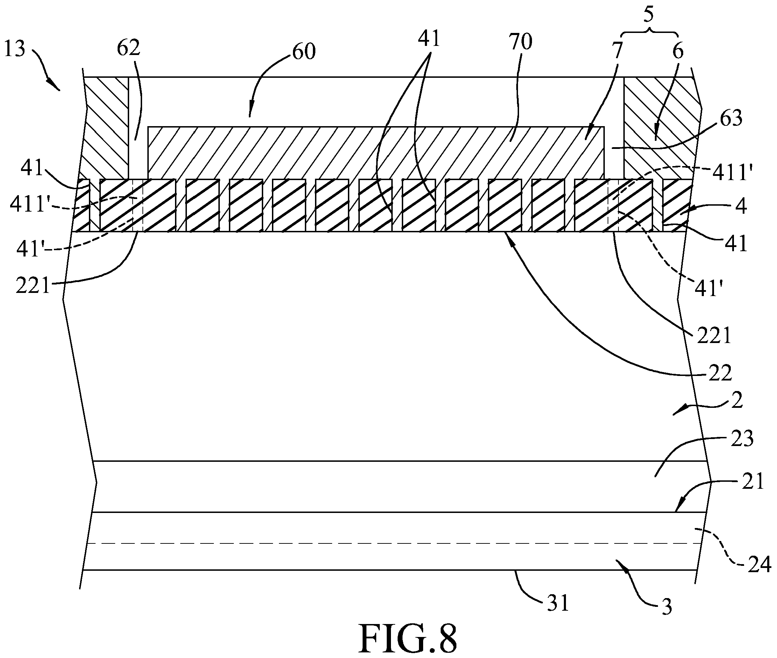

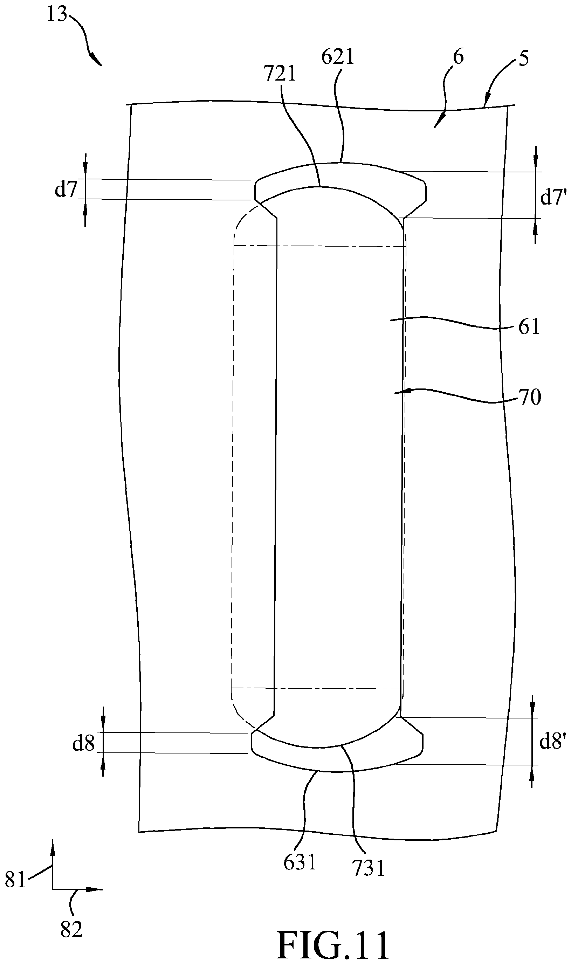

Referring to Figures 8, 9, and 11, the width (d1) of the first expansive opening portion (62) and the width (d3) of the second expansive opening portion (63) are larger than the width (d2) of the main opening portion (61) so that each of the first and second expansive opening portions (62, 63) expand in the second direction (82). In the screen printing procedure for forming the back electrode (5), if the collector opening (60) is misaligned with the bus electrode segment (70) in the second direction (82) (see Figure 11), the spacing (d7, d7') between the first outer expansive edge (621) of the collector opening (60) and the first outer edge (721) of the bus electrode segment (70) in the first direction (81) has relatively small variations. Likewise, the spacing (d8, d8') between the second outer expansive edge (631) of the collector opening (60) and the second outer edge (731) of the bus electrode segment (70) in the first direction (81) has relatively small variations as compared to the prior art. Therefore, the attaching strength between the bus electrode segment (70) and the ribbon (15) is enhanced.

In other words, under the aforesaid circumstance that a screen printing machine unavoidably has a certain amount of alignment error, this embodiment can provide larger margin for misalignment error between the collector opening (60) and the bus electrode segment (70) in the second direction (82) and the production yield may thus be increased. The expansion of each of the first and second expansive opening portions (62, 63) in the second direction (82) (i.e., the difference between the width (d1) of the first expansive opening portion (62) and the width (d2) of the main opening portion (61) and/or the difference between the width (d3) of the second expansive opening portion (63) and the width (d2) of the main opening portion (61)) is determined according to the ability of alignment machines.

In each of the collector openings (60) and a corresponding one of the bus electrode segments (70) of the embodiment, the first and second expansive opening portions (62, 63) have the same shape and size, and the first end second converging electrode portions (72, 73) have the same shape and size. However, it should be noted that the first and second expansive opening portions (62, 63) may have different shapes and/or sizes and that the first end second converging electrode portions (72, 73) may have different shapes and/or sizes

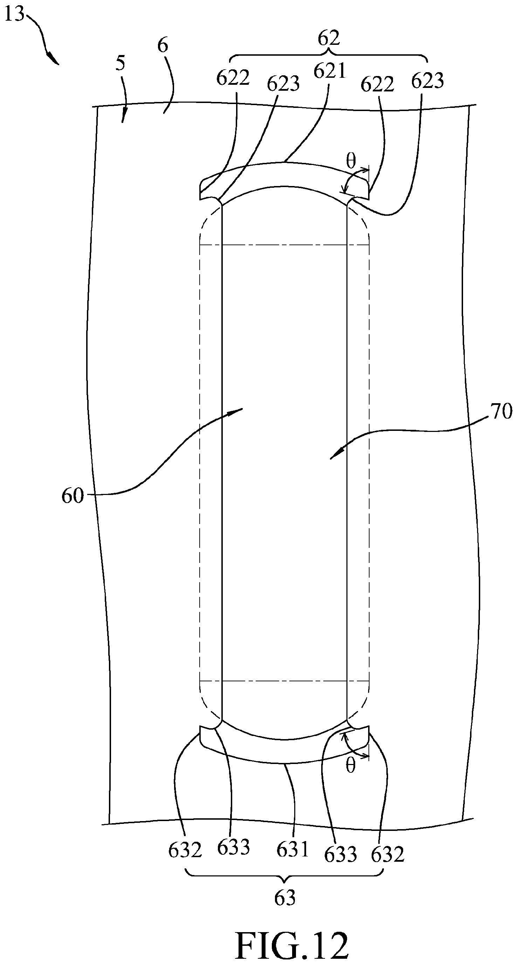

Referring to Figure 12, a second embodiment of a solar cell (13) according to this disclosure is similar to the first embodiment, except that the first connecting edges (623) of the first expansive opening portion (62) and the second connecting edges (633) of the second expansive opening portion (62) are convexed and that the angle (*θ*) defined by each of the first linear segments (622) and a corresponding one of the first connecting edges (623) and the angle (*θ*) defined by each of the second linear segments (632) and a corresponding one of the first connecting edges (633) are less than 90°.

A comparison of the second embodiment of the solar cell (13) shown in Figure 12 with the first embodiment of the solar cell (13) shown in Figure 9 reveals that, since the angle (*θ*) defined by each of the first linear segments (622) and a corresponding one of the first connecting edges (623) and the angle (*θ*) defined by each of the second linear segments (632) and a corresponding one of the second connecting edges (633) are greater than 90° in the first embodiment, the effect of reducing stress concentration during lamination and/or soldering encapsulation is better in the first embodiment.

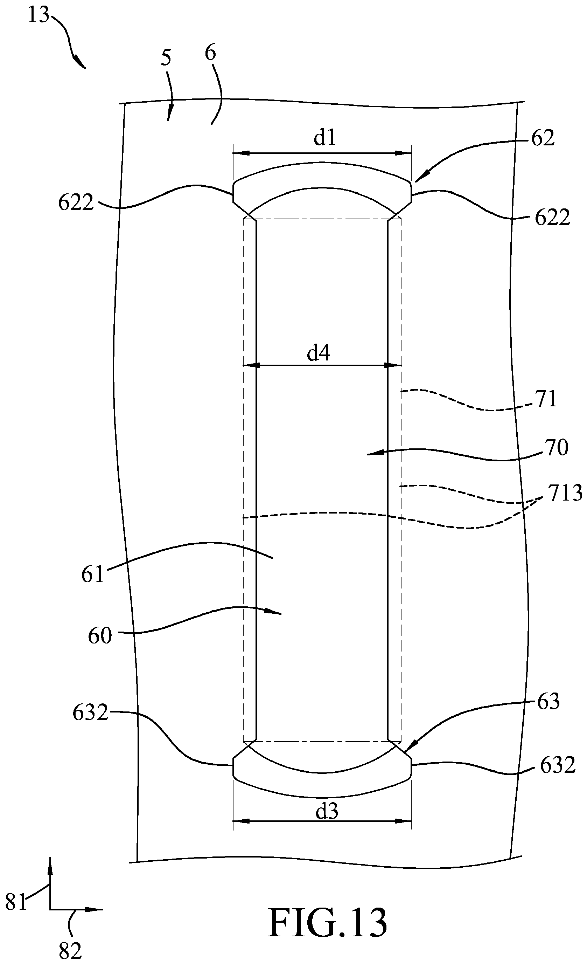

Figure 13 shows a third embodiment of a solar cell (13) according to this disclosure. The third embodiment is similar to the first embodiment, except that each of the lateral sides (713) is not aligned with a corresponding one of the first linear segments (622) and a corresponding one of the second linear segments (632), so that the width (d1) of the first expansive opening portion (62) and the width (d3) of the second expansive opening portion (63) are larger than the width (d4) between the lateral sides (713) of the main electrode portion (71). The margin for misalignment error in the second direction (82) in the third embodiment of the solar cell (13) may thus be further increased. However, the area covered by the collector layer (6) would be reduced so that the electrical characteristic of the solar cell (13) may be affected.

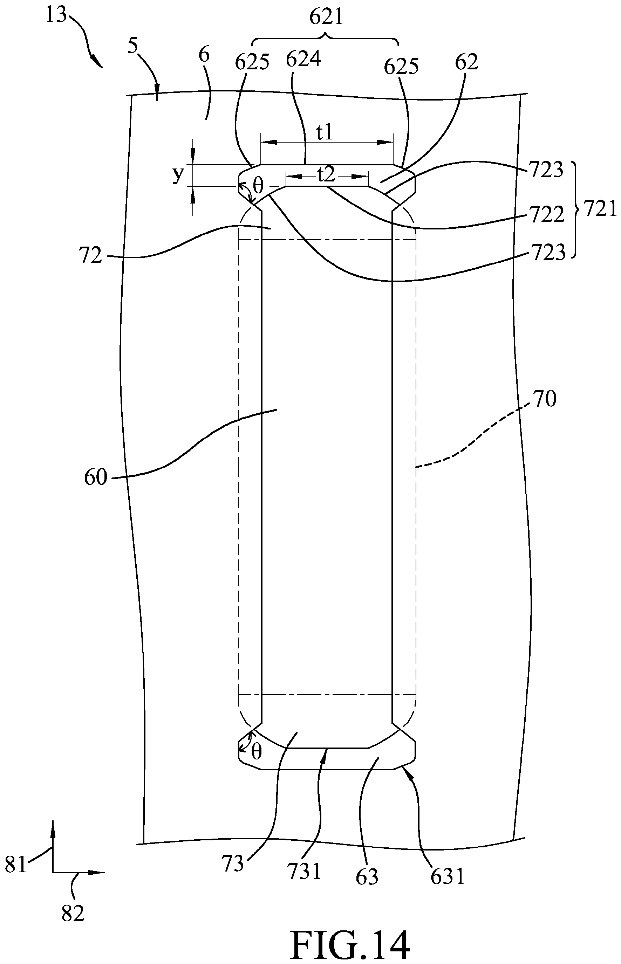

Figure 14 shows a fourth embodiment of a solar cell (13) according to this disclosure. The fourth embodiment is similar to the first embodiment, except that the first outer expansive edge (621) of the first expansive opening portion (62) and the second outer expansive edge (631) of the second expansive opening portion (63) are partially arcuate, and that the first outer edge (721) of the first converging electrode portion (72) and the second outer edge (731) of the second converging electrode portion (73) are partially arcuate. Since the first and second expansive opening portions (62, 63) have the same shape and the first and second converging electrode portions (72, 73) have the same shape in this embodiment, only the first outer expansive edge (621) of the first expansive opening portion (62) and the first outer edge (721) of the first converging electrode portion (72) will be further described below.

The first outer expansive edge (621) of the first expansive opening portion (62) includes a linear segment (624) extending along the second direction (82) and two arcuate segments (625) extending oppositely from two ends of the linear segment (624). The first outer edge (721) of the first converging electrode portion (72) includes a linear segment (722) extending along the second direction (82) and two arcuate segments (723) extending oppositely from two ends of the linear segment (622). The distance (y) between the linear segment (624) of the first outer expansive edge (621) and the linear segment (722) of the first outer edge (721) in the first direction (81) ranges from 150 to 750 *µ*m. The length (t1) of the linear segment (624) of the first outer expansive edge (621) is greater than a length (t2) of the linear segment (722) of the first outer edge (721) in the second direction (82). Similar to the first embodiment of the solar cell (13) shown in Figure 9, in the fourth embodiment of the solar cell (13), since the angle (*θ*) formed in the collector opening (60) as shown in Figure 14 is greater than 90°, stress concentration that may occur during lamination and/or soldering encapsulation can be reduced.

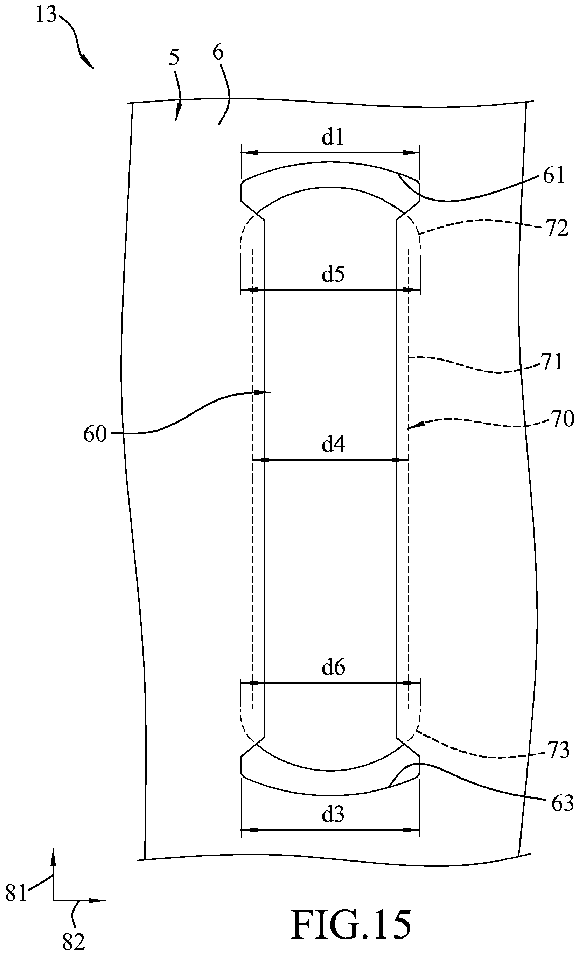

Figure 15 shows a fifth embodiment of a solar cell (13) according to this disclosure. The fifth embodiment is similar to the first embodiment, except that the first and second converging electrode portions (72, 73) of the bus electrode segment (70) have laterally expansive configurations expanding in the second direction (82). That is, the first converging electrode portion (72) of the bus electrode segment (70) has a largest width (d5) in the second direction (82), which is larger than the width (d4) of the main electrode portion (71), and the second converging electrode portion (73) of the bus electrode segment (70) has a largest width (d6) in the second direction (82), which is larger than the width (d4) of the main electrode portion (71). Additionally, the width (d1) of the first expansive opening portion (62) is not smaller than the largest width (d5) of the first converging electrode portion (72) of the bus electrode segment (70), and the width (d3) of the second expansive opening portion (63) is not smaller than the largest width (d6) of the second converging electrode portion (73) of the bus electrode segment (70).

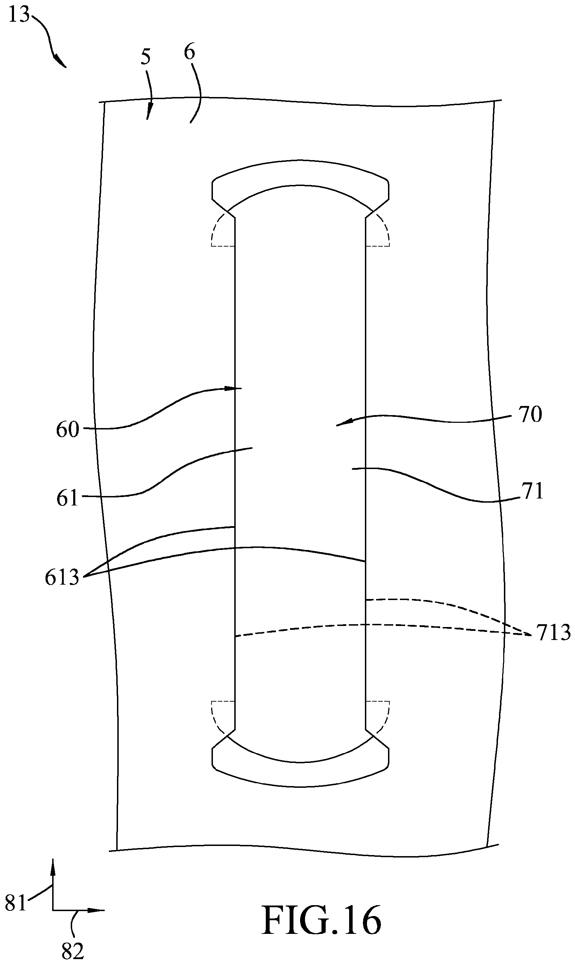

Figure 16 shows a sixth embodiment of a solar cell (13) according to this disclosure. The sixth embodiment is similar to the fifth embodiment, except that each of the lateral sides (713) of the bus electrode segment (70) is aligned with a corresponding one of two spaced lateral sides (613) of the main opening portion (61) of the collector opening (60), in which the lateral sides (613) of the main opening portion (61) of the collector opening (60) extend along the first direction (81) and are spaced apart from each other in the second direction (82).

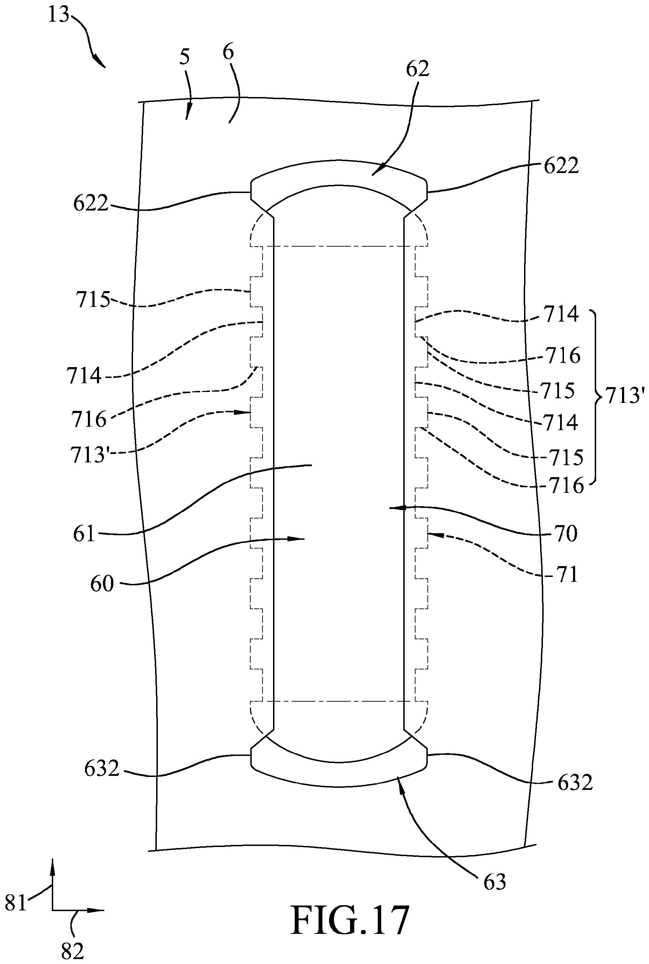

Figure 17 shows a seventh embodiment of a solar cell (13) according to this disclosure. The seventh embodiment is similar to the first embodiment, except that the main electrode portion (71) of the bus electrode segment (70) has two serrated lateral sides (713') extending along the first direction (81) and spaced apart from each other along the second direction (82). Each of the serrated lateral sides (713') includes a plurality of spaced linear segments (714) extending along the first direction (81) and distal from the other of the serrated lateral sides (713'), a plurality of spaced linear segments (715) extending along the first direction (81) and proximate to the other of the serrated lateral sides (713'), and a plurality of linear segments (716). Each of the linear segments (716) extends along the second direction (82) and interconnects a next one of the linear segments (714) and a next one of the linear segments (715).

The linear segments (715) of each of the serrated lateral sides (713') are aligned with a corresponding one of the first linear segments (622) of the first expansive opening portion (62) and a corresponding one of the second linear segments (632) of the second expansive opening portion (63). The main opening portion (61) of the collector opening (60) is located between the serrated lateral sides (713').

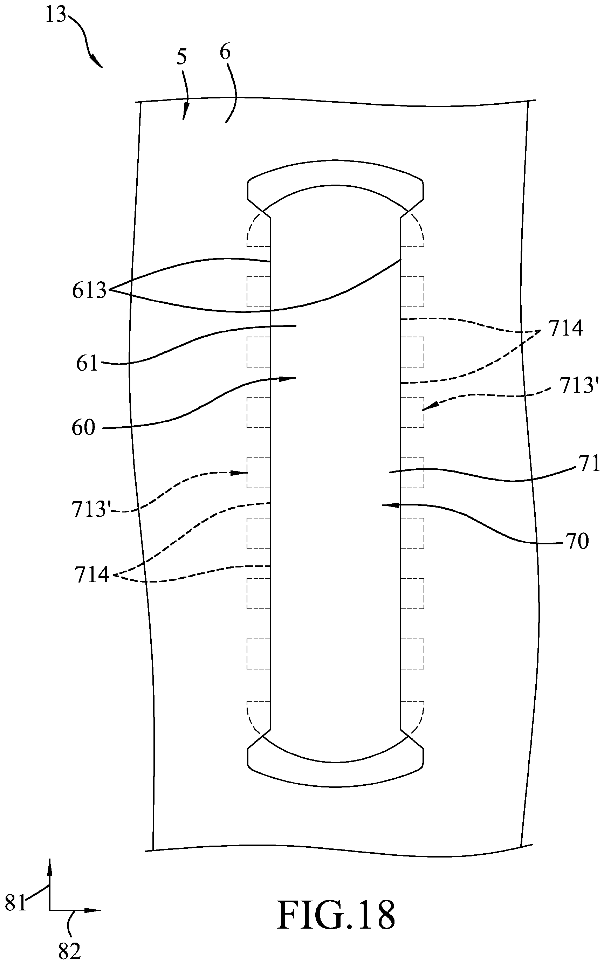

Figure 18 shows an eighth embodiment of a solar cell (13) according to this disclosure. The eighth embodiment is similar to the seventh embodiment, except that the linear segments (714) of each of the serrated lateral sides (713') are aligned with a corresponding one of two spaced lateral sides (613) of the main opening portion (61) of the collector opening (60), in which the lateral sides (613) of the main opening portion (61) of the collector opening (60) extend along the first direction (81) and are spaced apart from each other in the second direction (82).

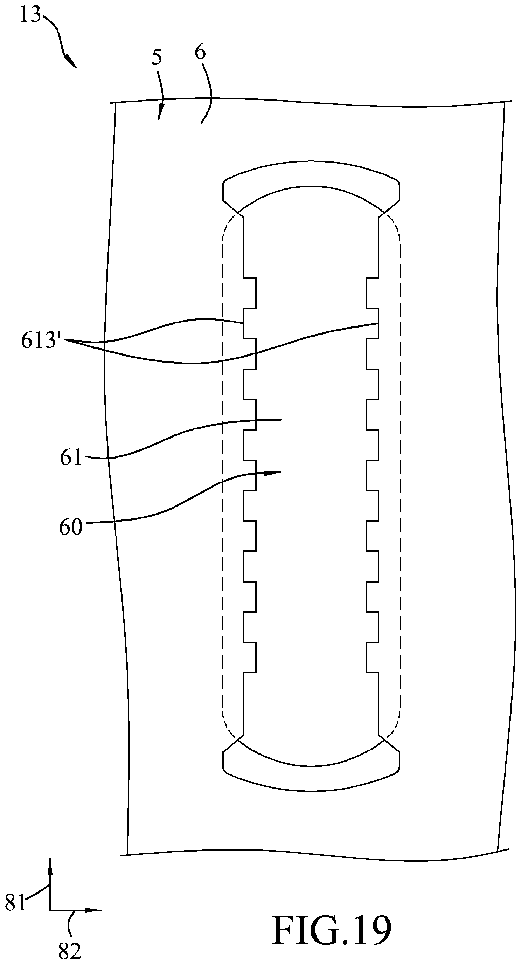

Figure 19 shows a ninth embodiment of a solar cell (13) according to this disclosure. The ninth embodiment is similar to the first embodiment, except that the main opening portion (61) of the collector opening (60) has two serrated lateral sides (613') extending along the first direction (81) and spaced apart from each other along the second direction (82).

In the embodiments described above, the bus electrode segments (70) in a solar cell (13) have the same configurations, and the collector openings (60) in a solar cell (13) likewise have the same configurations. However, in practice, the bus electrode segments (70) in a solar cell (13) may have different configurations, and the collector openings (60) in a solar cell (13) may also have different configurations.

It should be noted that, in the solar cell (13) of this disclosure, the collector openings (60) may be used in combination with any other conventional opening configurations, and the bus electrode segments (70) may be used in combination with any other conventional bus electrode segment configurations.

In the embodiments described above, the passivation layer (4) is disposed between the back surface (22) of the photovoltaic substrate (2) and the back electrode (5). The embodiments mentioned in this disclosure could also be applied to a solar cell without any passivation layer on its back surface. As a result, the collector layer (6) and the bus electrode (7) are in direct contact with the photovoltaic substrate (2).

## Claims

1. A solar cell (13) comprising:
a photovoltaic substrate (2) having a light-receiving surface (21) and a back surface (22) opposite to said light-receiving surface (21);
a front electrode (3) disposed on said light-receiving surface (21) of said photovoltaic substrate (2), and
a back electrode (5) disposed on said back surface (22) of said photovoltaic substrate (2), and including
a collector layer (6) disposed on said back surface (22) of said photovoltaic substrate (2) and having at least one collector opening (60) which extends along a first direction (81), and
a bus electrode (7) disposed on said back surface (22) of said photovoltaic substrate (2) and including at least one bus electrode segment (70) which extends along the first direction (81) and which corresponds in position to said collector opening (60), wherein said back surface (22) of said photovoltaic substrate (2) has an uncovered area (221) which is not covered by said bus electrode (7) and said collector layer (6), said solar cell (13) **characterized by**:
said at least one collector opening (60) including:
a first end portion (611),
a second end portion (622) opposite to said first end portion (611),
a main opening portion (61) between said first and second end portions (611, 612), and
a first expansive opening portion (62) formed at said first end portion (611),
said first expansive opening portion (62) having a first outer expansive edge (621) which is distal from said main opening portion (61) and which is at least partially arcuate, said first outer expansive edge (621) extending along a second direction (82) transverse to the first direction (81), said first expansive opening portion (62) having a width (d1) larger than a width (d2) of said main opening portion (61),
wherein said at least one bus electrode segment (70) is exposed from said at least one collector opening (60), and has a first end portion (711) and a second end portion (712), said first end portion (711) being spaced apart from said first outer expansive edge (621) and being exposed from said first expansive opening portion (62), said second end portion (712) being opposite to said first end portion (711) of said at least one bus electrode segment (70) in the first direction (81), said uncovered area (221) corresponding in position to said first expansive opening portion (62) of said at least one collector
opening (60) and underlying a spacing between, said first end portion (711) of said at least one bus electrode segment (70) and said first outer expansive edge (621) of said first expansive opening portion (62).

2. The solar cell (13) according to Claim 1, **characterized in that** said first outer expansive edge (621) of said first expansive opening portion (62) is entirely convexed to protrude away from said main opening portion (61).

3. The solar cell (13) according to Claim 1, **characterized in that** said first outer expansive edge (621) of said first expansive opening portion (62) is partially arcuate, and includes a linear segment (624) extending along the second direction (82).

4. The solar cell (13) according to Claim 1, **characterized in that** said at least one bus electrode segment (70) includes a main electrode portion (71) between said first and second end portions (711, 712) of said at least one bus electrode segment (70), and a first converging electrode portion (72) which is disposed at said first end portion (711) of said at least one bus electrode segment (70), which is connected with said main electrode portion (71) and which converges in the first direction (81) away from said main electrode portion (71).

5. The solar cell (13) according to Claim 4, **characterized in that** said first converging electrode portion (72) has a first outer edge (721) which is distal from said main electrode portion (71) and which is at least partially arcuate.

6. The solar cell (13) according to Claim 5, **characterized in that** said first outer edge (721) of said first converging electrode portion (72) is entirely convexed to protrude away from said main electrode portion (71).

7. The solar cell (13) according to Claim 5, **characterized in that** said first outer edge (721) of said first converging electrode portion (72) is partially arcuate, and includes a linear segment (722) extending along the second direction (82).

8. The solar cell (13) according to Claim 7, **characterized in that** said first outer expansile edge (621) of said first expansive opening portion (62) is partially arcuate and includes a linear segment (624) extending along the second direction (82), said linear segment (624) of said first outer expansive edge (621) having a length (t1) larger than a length (t2) of said linear segment (722) of said first outer edge (721) of said first converging electrode portion (72).

9. The solar cell (13) according to Claim 5, **characterized in that** said first outer expansive edge (621) of said first expansive opening portion (62) has a largest width (d1) in the second direction (82), which is not smaller than a largest width (d5) of said first converging electrode portion (72).

10. The solar cell (13) according to Claim 5, **characterized in that** said first outer expansive edge (621) of said first expansive opening portion (62) has a curvature corresponding to a curvature of said first outer edge (721) of said first converging electrode portion (72).

11. The solar cell (13) according to Claim 5, **characterized in that** at least a part of said first outer edge (721) of said first converging electrode portion (72) is registered with said first expansive opening portion (62).

12. The solar cell (13) according to Claim 3, **characterized in that** said first converging electrode portion (72) has a largest width (d5) larger than a width (d4) of said main electrode portion (71) of said at least one bus electrode segment (70).

13. The solar cell (13) according to Claim 4, **characterized in that** said main electrode portion (71) of said at least one bus electrode segment (70) has two serrated lateral sides (713') extending along the first direction (81) and spaced apart from each other along the second direction (82).

14. The solar cell (13) according to Claim 1, **characterized in that** said main opening portion (61) of said at least one collector opening (60) has two serrated lateral sides (613') extending along the first direction (81) and spaced apart from each other along the second direction (82).

15. The solar cell (13) according to Claim 1, further comprising a passivation layer (4) disposed between said back surface (22) of said photovoltaic substrate (2) and said back electrode (5), said passivation layer (4) including a plurality of linear openings (41) extending in the second direction (82), **characterized in that** at least one of said linear openings (41) has an imaginary line of extension in the second direction (82) intersecting with said uncovered area (221).

16. The solar cell (13) according to Claim 1, **characterized in that** said at least one collector opening (60) further includes a second expansive opening portion (63) formed at said second end portion (612) of said at least one collector opening (60), said second expansive opening portion (63) having a second outer expansive edge (631) which is distal from said main opening portion (61) and which is at least partially arcuate, said second expansive opening portion (63) having a width (d3) larger than a width (d2) of said main opening portion (61).

17. The solar cell (13) according to Claim 4, **characterized in that** said at least one bus electrode segment (70) further includes a second converging electrode portion (73) formed at said second end portion (712) of said at least one bus electrode segment (70) and converging in the first direction (81) away from said main electrode portion (71).

18. The solar cell (13) according to Claim 1, **characterized in that** said at least one collector opening (60) includes a plurality of collector openings (60) extending in the first direction (81) and spaced apart from each other along the second direction (82).

19. The solar cell (13) according to Claim 18, **characterized in that** said at least one bus electrode segment (70) includes a plurality of bus electrode segment (70), each of said collector openings (60) corresponding in position to at least one of said bus electrode segment (70).

20. A solar cell module **characterized by**:
a first plate (11),
a second plate (12) opposite to said first plate (11),
a solar cell (13) of Claim 1 disposed between said first and second plates (11, 12), and
an encapsulating material (14) disposed between said first and second plates (11, 12) and encapsulating said solar cell (13).

## Patentansprüche

1. Eine Solarzelle (13), umfassend:
ein photovoltaisches Substrat (2), das eine lichtempfangende Oberfläche (21) und eine Rückseite (22) gegenüber der lichtempfangenden Oberfläche (21) aufweist;
eine vordere Elektrode (3), die auf der lichtempfangenden Oberfläche (21) des photovoltaischen Substrats (2) angeordnet ist; und
eine hintere Elektrode (5), die auf der Rückseite (22) des photovoltaischen Substrats (2) angeordnet ist, und umfasst
eine Kollektorschicht (6), die auf der Rückseite (22) des photovoltaischen Substrats (2) angeordnet ist und die zumindest eine Kollektoröffnung (60) aufweist, die sich entlang einer ersten Richtung (81) erstreckt,
eine Buselektrode (7), die auf der Rückseite (22) des photovoltaischen Substrats (2) angeordnet ist und zumindest ein Buselektrodensegment (70) umfasst, welches sich entlang der ersten Richtung (81) erstreckt und welches in seiner Position der Kollektoröffnung (60) entspricht,
wobei die Rückseite (22) des photovoltaischen Substrats (2) eine unbedeckte Fläche (221) aufweist, die nicht von der Buselektrode (7) und der Kollektorschicht (6) bedeckt ist,
wobei die Solarzelle (13) **dadurch gekennzeichnet ist, dass** die zumindest eine Kollektoröffnung (60) umfasst:
einen ersten Endbereich (611),
einen zweiten Endbereich (612) gegenüber dem ersten Endbereich (611),
einen Hauptöffnungsbereich (61) zwischen den ersten und zweiten Endbereichen (611, 612) und
einen ersten expansiven Öffnungsbereich (62), der an dem ersten Endbereich (611) ausgebildet ist,
wobei der erste expansive Öffnungsbereich (62) eine erste äußere expansive Kante (621) aufweist, die sich distal von dem Hauptöffnungsbereich (61) befindet und die zumindest teilweise gekrümmt ist, wobei sich die erste äußere expansive Kante (621) entlang einer zweiten Richtung (82) quer zu der ersten Richtung (81) erstreckt, wobei der erste expansive Öffnungsbereich (62) eine Breite (d1) aufweist, die größer als eine Breite (d2) des Hauptöffnungsbereichs (61) ist, wobei das zumindest eines Buselektrodensegment (70) von der zumindest einen Kollektoröffnung (60) freigelegt ist und einen ersten Endbereich (711) und einen zweiten Endbereich (712) aufweist, wobei der erste Endbereich (711) von der ersten äußeren expansiven Kante (621) beabstandet ist und von dem ersten expansiven Öffnungsbereich (62) freigelegt ist, wobei sich der zweite Endbereich (712) in der ersten Richtung (81) gegenüber dem ersten Endbereich (711) des zumindest einen Buselektrodensegments (70) befindet, wobei die unbedeckte Fläche (221) in ihrer Position dem ersten expansiven Öffnungsbereich (62) der zumindest einen Kollektoröffnung (60) entspricht und einen Abstand zwischen dem ersten Endbereich (711) des zumindest einen Buselektrodensegments (70) und der ersten äußeren expansiven Kante (621) des ersten expansiven Öffnungsbereiches (62) unterliegt.

2. Die Solarzelle (13) nach Anspruch 1, **dadurch gekennzeichnet, dass** die erste äußere expansive Kante (621) des ersten expansiven Öffnungsbereichs (62) vollständig konvex ausgebildet ist, um von dem Hauptöffnungsbereich (61) weg hervorzuragen.

3. Die Solarzelle (13) nach Anspruch 1, **dadurch gekennzeichnet, dass** die erste äußere expansive Kante (621) des ersten expansiven Öffnungsbereichs (62) teilweise gekrümmt ist und ein lineares Segment (624) enthält, das sich entlang der zweiten Richtung (82) erstreckt.

4. Die Solarzelle (13) nach Anspruch 1, **dadurch gekennzeichnet, dass** das zumindest eine Buselektrodensegment (70) einen Hauptelektrodenbereich (71) zwischen den ersten und zweiten Endbereichen (711, 712) des zumindest einen Buselektrodensegments (70) enthält und ein erster konvergierender Elektrodenbereich (72), der an dem ersten Endbereich (711) des zumindest einen Buselektrodensegments (70) angeordnet ist, das mit dem Hauptelektrodenbereich (71) verbunden ist und das in die erste Richtung (81) weg von dem Hauptelektrodenbereich (71) konvergiert.

5. Die Solarzelle (13) nach Anspruch 4, **dadurch gekennzeichnet, dass** der erste konvergierende Elektrodenbereich (72) eine erste äußere Kante (721) aufweist, welche sich distal von dem Hauptelektrodenbereich (71) befindet und welche zumindest teilweise gekrümmt ist.

6. Die Solarzelle (13) nach Anspruch 5, **dadurch gekennzeichnet, dass** die erste äußere Kante (721) des ersten konvergierenden Elektrodenbereichs (72) vollständig konvex ausgebildet ist, um von dem Hauptelektrodenbereich (71) weg hervorzuragen.

7. Die Solarzelle (13) nach Anspruch 5, **dadurch gekennzeichnet, dass** die erste äußere Kante (721) des ersten konvergierenden Elektrodenbereichs (72) teilweise gekrümmt ist und ein lineares Segment (722) enthält, das sich entlang der zweiten Richtung (82) erstreckt.

8. Die Solarzelle (13) nach Anspruch 7, **dadurch gekennzeichnet, dass** die erste äußere expansive Kante (621) des ersten expansiven Öffnungsbereichs (62) teilweise gekrümmt ist und ein lineares Segment (624) enthält, das sich entlang der zweiten Richtung (82) erstreckt, wobei das lineare Segment (624) der ersten äußeren expansiven Kante (621) eine Länge (t1) hat, die größer ist als eine Länge (t2) des linearen Segments (722) der ersten äußeren Kante (721) des ersten konvergierenden Elektrodenbereichs (72).

9. Die Solarzelle (13) nach Anspruch 5, **dadurch gekennzeichnet, dass** die erste äußere expansive Kante (621) des ersten expansiven Öffnungsbereichs (62) eine größte Breite (d1) in der zweite Richtung (82) hat, welche nicht kleiner ist als eine größte Breite (d5) des ersten konvergierenden Elektrodenbereichs (72).

10. Die Solarzelle (13) nach Anspruch 5, **dadurch gekennzeichnet, dass** die erste äußere expansive Kante (621) des ersten expansiven Öffnungsbereichs (62) eine Krümmung aufweist, die einer Krümmung der ersten äußeren Kante (721) des ersten konvergierenden Elektrodenbereichs (72) entspricht.

11. Die Solarzelle (13) nach Anspruch 5, **dadurch gekennzeichnet, dass** sich zumindest ein Teil der ersten äußeren Kante (721) des ersten konvergierenden Elektrodenbereichs (72) mit dem ersten expansiven Öffnungsbereich (62) deckt.

12. Die Solarzelle (13) nach Anspruch 3, **dadurch gekennzeichnet, dass** der erste konvergierende Elektrodenbereich (72) eine größte Breite (d5) hat, die größer als eine Breite (d4) des Hauptelektrodenbereichs (71) des zumindest einen Buselektrodensegments (70) ist.

13. Die Solarzelle (13) nach Anspruch 4, **dadurch gekennzeichnet, dass** der Hauptelektrodenbereich (71) des zumindest einen Buselektrodensegments (70) zwei gezahnte laterale Seiten (713') aufweist, die sich entlang der ersten Richtung (81) erstrecken und voneinander entlang der zweiten Richtung (82) beabstandet sind.

14. Die Solarzelle (13) nach Anspruch 1, **dadurch gekennzeichnet, dass** der Hauptöffnungsbereich (61) der zumindest einen Kollektoröffnung (60) zwei gezahnte laterale Seiten (613') aufweist, die sich entlang der ersten Richtung (81) erstrecken und voneinander entlang der zweiten Richtung (82) beabstandet sind.

15. Die Solarzelle (13) nach Anspruch 1, ferner umfassend eine Passivierungsschicht (4), die zwischen der Rückseite (22) des photovoltaischen Substrats (2) und der hinteren Elektrode (5) angeordnet ist, wobei die Passivierungsschicht (4) eine Mehrzahl an linearen Öffnungen (41) enthält, die sich in die zweite Richtung (82) erstrecken, **dadurch gekennzeichnet, dass** zumindest eine der linearen Öffnungen (41) eine imaginäre Erstreckungslinie in die zweite Richtung (82) aufweist, die die unbedeckte Fläche (221) schneidet.

16. Die Solarzelle (13) nach Anspruch 1, **dadurch gekennzeichnet, dass** die zumindest eine Kollektoröffnung (60) ferner einen zweiten expansiven Öffnungsbereich (63) umfasst, der an dem zweiten Endbereich (612) der zumindest einen Kollektoröffnung (60) ausgebildet ist, wobei der zweite expansive Öffnungsbereich (63) eine zweite äußere expansive Kante (631) aufweist, welche sich distal von dem Hauptöffnungsbereich (61) befindet und welche zumindest teilweise gekrümmt ist, wobei der zweite expansive Öffnungsbereich (63) eine Breite (d3) hat, die größer ist als eine Breite (d2) des Hauptöffnungsbereichs (61).

17. Die Solarzelle (13) nach Anspruch 4, **dadurch gekennzeichnet, dass** das zumindest eine Buselektrodensegment (70) ferner einen zweiten konvergierenden Elektrodenbereich (73) enthält, der an dem zweiten Endbereich (712) des zumindest einen Buselektrodensegments (70) ausgebildet ist und in die erste Richtung (81) weg von dem Hauptelektrodenbereich (71) konvergiert.

18. Die Solarzelle (13) nach Anspruch 1, **dadurch gekennzeichnet, dass** die zumindest eine Kollektoröffnung (60) eine Mehrzahl an Kollektoröffnungen (60) umfasst, die sich in die erste Richtung (81) erstrecken und entlang der zweiten Richtung (82) voneinander beabstandet sind.

19. Die Solarzelle (13) nach Anspruch 18, **dadurch gekennzeichnet, dass** das zumindest eine Buselektrodensegment (70) eine Mehrzahl an Buselektrodensegmenten (70) umfasst, wobei jede der Kollektoröffnungen (60) in ihrer Position zumindest einem der Buselektrodensegmente (70) entspricht.

20. Ein Solarzellenmodul, **gekennzeichnet durch**:
eine erste Platte (11),
eine zweite Platte (12) gegenüber der ersten Platte (11),
eine Solarzelle (13) nach Anspruch 1, die zwischen den ersten und zweiten Platten (11, 12) angeordnet ist, und
ein einkapselndes Material (14), das zwischen den ersten und zweiten Platten (11,12) angeordnet ist und die Solarzelle (13) einkapselt.

## Revendications

1. Cellule solaire (13), comprenant:
un substrat photovoltaïque (2) possédant une surface de réception de lumière (21) et une surface arrière (22) opposée à ladite surface de réception de lumière (21);
une électrode avant (3) disposée sur ladite surface de réception de lumière (21) dudit substrat photovoltaïque (2); et
une électrode arrière (5) disposée sur ladite surface arrière (22) dudit substrat photovoltaïque (2), et incluant
une couche collectrice (6) disposée sur ladite surface arrière (22) dudit substrat photovoltaïque (2) et possédant au moins une ouverture collectrice (60) qui s'étend le long d'une première direction (81), et
une électrode bus (7) disposée sur ladite surface arrière (22) dudit substrat photovoltaïque (2) et incluant au moins un segment d'électrode bus (70) qui s'étend le long de la première direction (81) et qui correspond en position à ladite ouverture collectrice (60),
dans laquelle
ladite surface arrière (22) dudit substrat photovoltaïque (2) possède une zone non couverte (221) qui n'est pas couverte par ladite électrode bus (7) et ladite couche collectrice (6),
ladite cellule solaire (13) étant **caractérisée en ce que**:
ladite au moins une ouverture collectrice (60) inclut:
une première portion d'extrémité (611),
une seconde portion d'extrémité (612) opposée à ladite première portion d'extrémité (611),
une portion d'ouverture principale (61) entre lesdites première et seconde portions d'extrémité (611, 612), et
une première portion d'ouverture expansive (62) formée à ladite première portion d'extrémité (611),
ladite première portion d'ouverture expansive (62) possédant un premier bord expansif extérieur (621) qui est distal par rapport à ladite portion d'ouverture principale (61) et qui est au moins partiellement arqué, ledit premier bord expansif extérieur (621) s'étendant le long d'une seconde direction (82) transversale à la première direction (81), ladite première portion d'ouverture expansive (62) possédant une largeur (d1) supérieure à une largeur (d2) de ladite portion d'ouverture principale (61), dans laquelle ledit au moins un segment d'électrode bus (70) est exposé à partir de ladite au moins une ouverture collectrice (60), et possède une première portion d'extrémité (711) et une seconde portion d'extrémité (712), ladite première portion d'extrémité (711) étant espacée dudit premier bord expansif extérieur (621) et étant exposé à partir de ladite première portion d'ouverture expansive (62), ladite seconde portion d'extrémité (712) étant opposée à ladite première portion d'extrémité (711) dudit au moins un segment d'électrode bus (70) dans la première direction (81), ladite zone non couverte (221) correspondant en position à ladite première portion d'ouverture expansive (62) de ladite au moins une ouverture collectrice (60) et se trouvant sous un espacement entre ladite première portion d'extrémité (711) dudit au moins un segment d'électrode bus (70) et ledit premier bord expansif extérieur (621) de ladite première portion d'ouverture expansive (62).

2. Cellule solaire (13) selon la revendication 1, **caractérisée en ce que** ledit premier bord expansif extérieur (621) de ladite première portion d'ouverture expansive (62) est entièrement convexe pour faire saillie et s'éloigner de ladite portion d'ouverture principale (61).

3. Cellule solaire (13) selon la revendication 1, **caractérisée en ce que** ledit premier bord expansif extérieur (621) de ladite première portion d'ouverture expansive (62) est partiellement arqué, et inclut un segment linéaire (624) s'étendant le long de la seconde direction (82).

4. Cellule solaire (13) selon la revendication 1, **caractérisée en ce que** ledit au moins un segment d'électrode bus (70) inclut une portion d'électrode principale (71) entre lesdites première et seconde portions d'extrémité (711, 712) dudit au moins un segment d'électrode bus (70), et une première portion d'électrode convergente (72) qui est disposée à ladite première portion d'extrémité (711) dudit au moins un segment d'électrode bus (70), qui est connecté à ladite portion d'électrode principale (71) et qui converge dans la première direction (81) pour s'éloigner de ladite portion d'électrode principale (71)

5. Cellule solaire (13) selon la revendication 4, **caractérisée en ce que** ladite première portion d'électrode convergente (72) possède un premier bord extérieur (721) qui est distal par rapport à ladite portion d'électrode principale (71) et qui est au moins partiellement arqué.

6. Cellule solaire (13) selon la revendication 5, **caractérisée en ce que** ledit premier bord extérieur (721) de ladite première portion d'électrode convergente (72) est entièrement convexe pour faire saillie pour s'éloigner de ladite portion d'électrode principale (71).

7. Cellule solaire (13) selon la revendication 5, **caractérisée en ce que** ledit premier bord extérieur (721) de ladite première portion d'électrode convergente (72) est partiellement arqué, et inclut un segment linéaire (722) s'étendant le long de la seconde direction (82).

8. Cellule solaire (13) selon la revendication 7, **caractérisée en ce que** ledit premier bord expansif extérieur (621) de ladite portion d'ouverture expansive (62) est partiellement arqué et inclut un segment linéaire (624) s'étendant le long de la seconde direction (82), ledit segment linéaire (624) dudit premier bord expansif extérieur (621) possédant une longueur (t1) supérieure à une longueur (t2) dudit segment linéaire (722) dudit premier bord extérieur (721) de ladite première portion d'électrode convergente (72).

9. Cellule solaire (13) selon la revendication 5, **caractérisé en ce que** ledit premier bord expansif extérieur (621) de ladite première portion d'ouverture expansive (62) possède une largeur la plus grande (d1) dans la seconde direction (82), qui n'est pas plus petite qu'une largeur la plus grande (d5) de ladite première portion d'électrode convergente (72).

10. Cellule solaire (13) selon la revendication 5, **caractérisée en ce que** ledit premier bord expansif extérieur (621) de ladite première portion d'ouverture expansive (62) possède une courbure correspondant à une courbure dudit premier bord extérieur (721) de ladite première portion d'électrode convergente (72).

11. Cellule solaire (13) selon la revendication 5, **caractérisée en ce qu'**au moins une partie dudit premier bord extérieur (721) de ladite première portion d'électrode convergente (72) est mise en coïncidence avec ladite première portion d'ouverture expansive (62).

12. Cellule solaire (13) selon la revendication 3, **caractérisée en ce que** ladite première portion d'électrode convergente (72) possède une largeur la plus grande (d5) supérieure à une largeur (d4) de ladite portion d'électrode principale (71) dudit au moins un segment d'électrode bus (70).

13. Cellule solaire (13) selon la revendication 4, **caractérisée en ce que** ladite portion d'électrode principale (71) dudit au moins un segment d'électrode bus (70) possède deux côtés latéraux crénelés (713') s'étendant le long de la première direction (81) et espacée l'un de l'autre le long de la seconde direction (82).

14. Cellule solaire (13) selon la revendication 1, **caractérisée en ce que** ladite portion d'ouverture principale (61) de ladite au moins une ouverture collectrice (60) possède deux côtés latéraux crénelés (613') s'étendant le long de la première direction (81) et espacés l'un de l'autre le long de la seconde direction (82).

15. Cellule solaire (13) selon la revendication 1, comprenant en outre une couche de passivation (4) disposée entre ladite surface arrière (22) dudit substrat photovoltaïque (2) et ladite électrode arrière (5), ladite couche de passivation (4) incluant une pluralité d'ouvertures linéaires (41) s'étendant dans la seconde direction (82), **caractérisée en ce qu'**au moins l'une desdites ouvertures linéaires (41) possède une ligne imaginaire d'extension dans la seconde direction (82) croisant ladite zone non couverte (221).

16. Cellule solaire (13) selon la revendication 1, **caractérisée en ce que** ladite au moins une ouverture collectrice (60) inclut en outre une seconde portion d'ouverture expansive (63) formée à ladite seconde portion d'extrémité (612) de ladite au moins une ouverture collectrice (60), ladite seconde portion d'ouverture expansive (63) possédant un second bord expansif extérieur (631) qui est distal par rapport à ladite portion d'ouverture principale (61) et qui est au moins partiellement arqué, ladite seconde portion d'ouverture expansive (63) possédant une largeur (d3) supérieure à une largeur (d2) de ladite portion d'ouverture principale (61).

17. Cellule solaire (13) selon la revendication 4, **caractérisée en ce que** ledit au moins un segment d'électrode bus (70) inclut en outre une seconde portion d'électrode convergente (73) formée à ladite seconde portion d'extrémité (712) dudit au moins un segment d'électrode bus (70) et convergeant dans la première direction (81) pour s'éloigner de ladite portion d'électrode principale (71).

18. Cellule solaire (13) selon la revendication 1, **caractérisée en ce que** ladite au moins une ouverture collectrice (60) inclut une pluralité d'ouvertures collectrices (60) s'étendant dans la première direction (81) et espacées les unes des autres le long de la seconde direction (82).

19. Cellule solaire (13) selon la revendication 18, **caractérisée en ce que** ledit au moins un segment d'électrode bus (70) inclut une pluralité de segments d'électrode bus (70), chacune desdites ouvertures collectrices (60) correspondant en position à au moins l'un dudit segment d'électrode bus (70).

20. Module à cellule solaire, **caractérisé par**:
une première plaque (11),
une seconde plaque (12) opposée à ladite première plaque (11),
une cellule solaire (13) de la revendication 1 disposée entre lesdites première et seconde plaques (11, 12), et
un matériau d'encapsulation (14) disposé entre lesdites première et seconde plaques (11, 12) et encapsulant ladite cellule solaire (13).
